(19) Europäisches Patentamt
European Patent Office
Office européen des brevets

(11) **EP 0 882 989 B1**

(12) **FASCICULE DE BREVET EUROPEEN**

(45) Date de publication et mention
de la délivrance du brevet:
**22.09.2004 Bulletin 2004/39**

(51) Int Cl.⁷: $G01R\ 15/06$, $H01B\ 17/00$

(21) Numéro de dépôt: **98401152.8**

(22) Date de dépôt: **14.05.1998**

(54) **Capteur électro-optique à diviseur de tension massif**

Elektrooptischer Sensor mit einem Spannungsteilereinheit

Electro-optical sensing device with a voltage divider unit

(84) Etats contractants désignés:
**CH DE ES GB IT LI NL SE**

(30) Priorité: **06.06.1997 FR 9707012**

(43) Date de publication de la demande:
**09.12.1998 Bulletin 1998/50**

(73) Titulaire: **GEC ALSTHOM T & D BALTEAU
92120 Montrouge (FR)**

(72) Inventeur: **Chatrefou, Denis
91860 Epinay sous Senart (FR)**

(74) Mandataire: **Poulin, Gérard et al
Société BREVATOME
3, rue du Docteur Lancereaux
75008 Paris (FR)**

(56) Documents cités:
**FR-A- 2 240 454**

- **PATENT ABSTRACTS OF JAPAN vol. 007, no. 270 (P-240), 2 décembre 1983 & JP 58 150869 A (TOKYO SHIBAURA DENKI KK), 7 septembre 1983,**
- **PATENT ABSTRACTS OF JAPAN vol. 015, no. 419 (E-1126), 24 octobre 1991 & JP 03 175606 A (MITSUBISHI ELECTRIC CORP), 30 juillet 1991,**
- **PATENT ABSTRACTS OF JAPAN vol. 018, no. 045 (P-1681), 24 janvier 1994 & JP 05 273256 A (FURUKAWA ELECTRIC CO LTD:THE), 22 octobre 1993,**

EP 0 882 989 B1

## Description

L'invention concerne un capteur électro-optique de tension pour déterminer la tension d'une ligne électrique, comprenant un diviseur de tension relié à la ligne électrique et à une masse et ayant deux compartiments isolants séparés par une électrode intermédiaire reliée à une cellule de Pockels, l'électrode intermédiaire fournissant à la cellule de Pockels une tension réduite de la tension fournie par la ligne électrique au diviseur de tension.

Un tel capteur est utilisé dans les réseaux de distribution pour déterminer la valeur de la tension des lignes électriques nécessaire au "Comptage" du transit électrique et à la "Protection" des réseaux.

D'une manière connue, la cellule de Pockels comprend un cristal électro-optique, par exemple un oxyde de Bismuth et de Germanium ou de Bismuth et de Silicium. L'effet Pockels désigne l'apparition d'une biréfringence du cristal provoquée par l'application d'une tension électrique entre deux faces du cristal revêtues d'un dépôt conducteur.

La cellule de Pockels comprend également une fibre optique d'entrée reliée à une diode électroluminescente émettant un faisceau lumineux incident à travers un polariseur et une lame déphasante. En traversant le cristal électro-optique le faisceau lumineux incident voit sa polarisation varier. Un analyseur disposé sur le trajet du faisceau lumineux transmis transforme la variation de polarisation à la sortie du cristal en une variation d'intensité lumineuse transportée par une fibre optique de sortie jusqu'à un détecteur à photodiode situé dans une électronique à distance.

La variation de polarisation dépend de la tension appliquée entre les faces conductrices du cristal électro-optique.

Il est possible de montrer que dans un mode particulier de fonctionnement de la cellule de Pockels la puissance lumineuse instantanée reçue par la photodiode rapportée à la puissance continue émise par la diode électroluminescente dépend de la tension appliquée U sous la forme d'un sinus du produit k*U, où k est un coefficient de couplage électro-optique caractéristique du cristal de la cellule de Pockels utilisée.

La cellule de Pockels permet de déterminer une tension appliquée U jusqu'à une valeur typique de 10 000 volts, habituellement désignée par tension quart d'onde du cristal électro-optique.

Au delà de cette valeur limite, l'évolution temporelle de la puissance lumineuse instantanée reçue n'est plus monotone par rapport à l'évolution temporelle de la tension appliquée U.

Une première solution pour palier ce problème consiste à dédoubler le faisceau lumineux incident afin de produire une autre variation trigonométrique de la puissance lumineuse.

Elle présente néanmoins deux inconvénients majeurs. D'une part, la nécessité d'utiliser un cristal électro-optique de grande longueur pour supporter la tension constitue une limite technique (aujourd'hui à 25 cm de longueur) et un surcoût très élevé. D'autre part, la bande passante du capteur électro-optique est considérablement limitée et est incompatible avec la mesure de signaux transitoires rapides de la tension comme ceux correspondant aux spécifications de la voie "Protection".

Une deuxième solution consiste à associer la cellule de Pockels à un diviseur de tension. Ce dernier comprend en général une colonne capacitive formée de capacités élémentaires toutes identiques et constituées par exemple de feuilles d'Aluminium servant d'armatures séparées par des feuilles isolantes de papier ou de polypropylène, l'ensemble étant immergé dans un liquide d'isolation par exemple à base d'huile.

Une électrode intermédiaire reliée électriquement à une des faces conductrices du cristal électro-optique de la cellule de Pockels sépare la colonne capacitive en deux compartiments isolants. Une tension totale appliquée à la colonne génère une tension réduite à la cellule de Pockels, le rapport entre les tensions étant déterminé par les capacités de deux compartiments de la colonne.

Pour déterminer la tension de la ligne électrique, la cellule de Pockels est associée à une colonne capacitive disposée à l'intérieur et sur toute la longueur d'un isolateur supportant la ligne électrique. La longueur de l'isolateur rempli d'un gaz sous pression est choisie en fonction de la tension de la ligne électrique de telle sorte que la capacité des deux compartiments permette de diviser suffisamment la tension de ligne pour que la tension réduite soit inférieure à la tension quart d'onde du cristal électro-optique de la cellule de Pockels utilisée.

Un tel capteur électro-optique de tension pose néanmoins deux problèmes.

D'une part, en cas de court-circuit interne, dû par exemple à une défaillance de l'isolation de la colonne capacitive, l'augmentation de température et de pression qui en résultent conduisent généralement à une explosion de l'isolateur, qu'il soit constitué d'un matériau vitreux, par exemple une porcelaine, ou composite.

D'autre part, la colonne capacitive qui est en pratique disposée verticalement dans l'isolateur peut subir dans le temps des variations de dimension d'origine mécanique dues à un écrasement différent des capacités élémentaires entre celles situées dans le bas et celles situées dans le haut de la colonne, ce phénomène pouvant être encore plus marqué dans le cas où le liquide d'isolation à base d'huile est remplacé par un gaz. De plus, des variations de dimension d'origine thermique peuvent résulter d'une dilatation différente des capacités élémentaires sous l'effet d'un gradient de température entre le bas et la haute de la colonne. Ces variations de dimensions ont pour conséquence de conduire à des erreurs de mesure incompatibles avec la voie "Comptage" du capteur électro-optique.

Le but de l'invention est donc de proposer un capteur électro-optique de tension comprenant une cellule de Pockels associée à un diviseur de tension qui présente une sécurité accrue vis à vis des risques de court-circuit et qui confère au capteur une grande fiabilité et une grande précision de mesure.

A cet effet, l'invention a pour objet un capteur électro-optique de tension pour déterminer la tension d'une ligne électrique, ledit capteur comprenant un diviseur de tension pouvant être relié à la ligne électrique et à une masse et ayant deux compartiments isolants séparés par une électrode intermédiaire ainsi qu'une cellule de Pockels, ladite électrode intermédiaire étant reliée à la cellule de Pockels et fournissant à la cellule de Pockels une tension réduite de la tension pouvant être fournie par la ligne électrique au diviseur de tension, caractérisé en ce que chaque compartiment isolant est massif et est constitué d'un bloc diélectrique homogène.

Les deux compartiments isolants constitués d'un bloc diélectrique homogène, le terme de bloc indiquant que chaque compartiment est massif, confèrent au capteur électro-optique une fiabilité vis à vis des courts-circuits beaucoup plus élevée que celle des diviseurs de tension à colonne capacitive décrite précédemment. La tenue mécanique du diviseur de tension est elle aussi fortement améliorée, la résistance à l'écrasement des blocs étant très supérieure à celle des capacités élémentaires à feuilles conductrices et isolantes.

D'autres caractéristiques et avantages de l'invention apparaîtront à la lecture de la description d'un mode de réalisation du capteur électro-optique illustré par les dessins.

La figure 1 est une coupe schématique d'un diviseur de tension à deux blocs diélectriques homogènes.

La figure 2 montre en coupe un capteur électro-optique de tension comprenant un diviseur de tension associé à une cellule de Pockels.

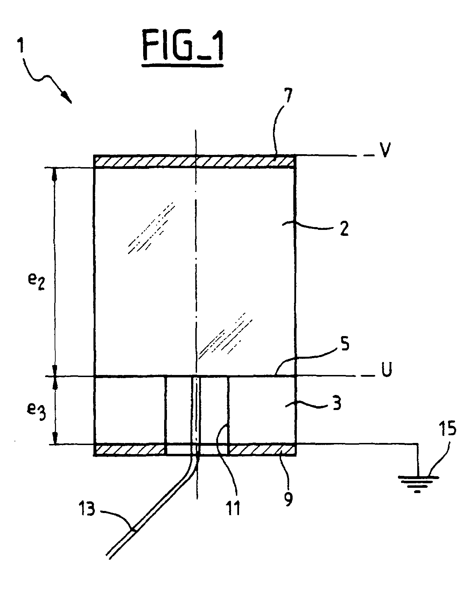

Figure 1, un diviseur de tension 1 comprend deux blocs diélectriques homogènes 2 et 3. Le bloc 2 désigné par la suite de bloc supérieur et le bloc 3 désigné par la suite de bloc inférieur ont une forme cylindrique et possèdent une section identique, par exemple circulaire.

Les sections droites des deux blocs sont revêtues d'un dépôt conducteur par exemple d'Aluminium obtenu par évaporation sous vide ou par tout autre procédé chimique. Les deux blocs sont ensuite assemblés par simple pression ou par collage conducteur. Les dépôts et le collage conducteur forment ensemble l'électrode intermédiaire 5. Le diviseur de tension est lui même monté entre deux armatures opposées 7 et 9.

L'une 9 des deux armatures étant placée à un potentiel électrique 15 constant ou nul appelé masse, une tension électrique totale V appliquée sur l'armature 7 engendre une tension réduite U sur l'électrode intermédiaire 5 à l'interface entre les deux blocs. Le rapport entre V et U, appelé encore rapport de division R, est déterminé par les épaisseurs $e_2$ et $e_3$ des deux blocs selon la relation

$$R = \frac{U}{V} = \frac{e_3}{e_2 + e_3}$$

Il faut noter que cette relation suppose que les deux blocs du diviseur de tension sont constitués d'un même matériau, mais se généralise aisément au cas où les deux blocs sont réalisés à partir de matériaux différents.

Le bloc inférieur 3 présente un évidement axial 11 pour permettre le passage d'un fil de contact 13 connecté à l'électrode intermédiaire 5.

Par comparaison avec une colonne capacitive à empilement de capacités élémentaires, dans laquelle le rapport R entre les tensions V et U ne peut prendre que des valeurs discrètes, le diviseur de tension de la figure 1 permet d'obtenir un rapport continu par le bais des épaisseurs $e_2$ et $e_3$.

De préférence les deux compartiments du diviseur de tension sont constitués de blocs de verre ou de vitrocéramique. Ces derniers offrent des constantes diélectriques relatives de l'ordre de 8 plus élevées que celles de verres de l'ordre de 3. Ces matériaux permettent d'augmenter la capacité globale du diviseur de tension vis à vis de capacités parasites.

Il faut remarquer également que ces matériaux sont relativement bon marché et simples à usiner.

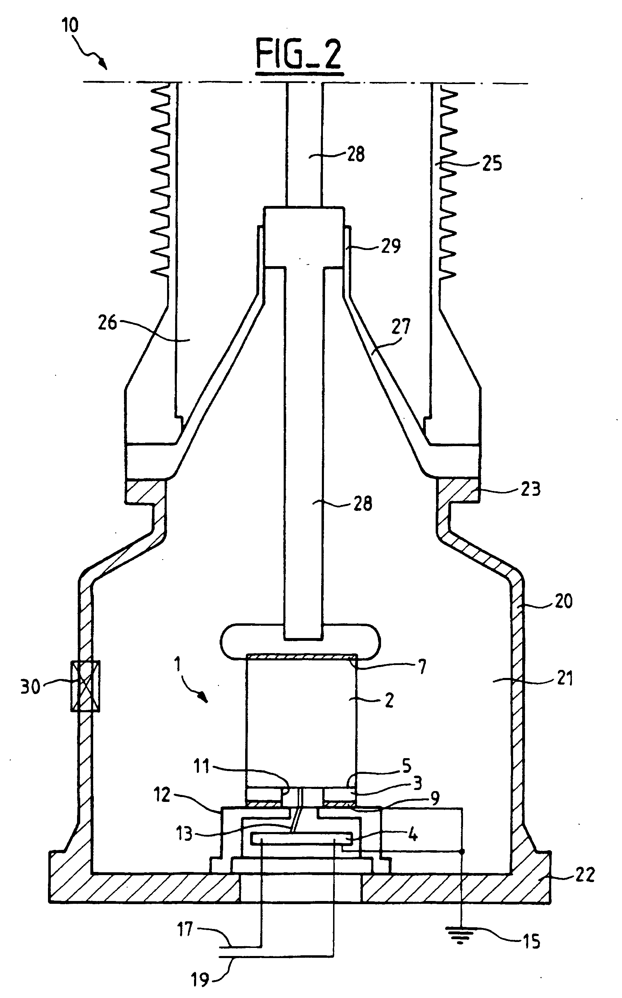

Figure 2, un capteur élecro-optique de tension 10 comprend un diviseur de tension 1 tel celui décrit précédemment disposé à l'intérieur d'une enceinte blindée 20 par exemple métallique et remplie d'un gaz isolant 21 sous pression par exemple l'hexafluorure de Soufre $SF_6$ ou l'Azote $N_2$ sec.

Un autre isolant gazeux neutre et sec peut convenir pour le remplissage de l'enceinte blindée, de même qu'un isolant solide par exemple en polyéthylène ou en silicone, intéressant à la fois sur le plan économique et pour le respect de normes d'utilisation vis à vis de la protection de l'environnement.

Les isolants gazeux compatibles avec les blocs diélectriques homogènes du diviseur de tension permettent de s'affranchir d'isolants à base d'huile et ainsi de limiter considérablement les risques d'explosion en cas de court-circuit entre les armatures du diviseur de tension.

L'enceinte blindée est électriquement reliée par sa base 22 à une masse 15. Un bâti 12 reposant à l'intérieur de l'enceinte blindée 20 sur la base 22 supporte le diviseur de tension 1 et contient une cellule de Pockels 4 du type de celle qui a été décrite précédemment.

Un fil conducteur 13 assure le contact entre l'électrode intermédiaire 5 et une face conductrice du cristal électro-optique de la cellule de Pockels 4, l'autre face conductrice étant reliée à la masse 15. De cette façon, une tension totale V appliquée au diviseur de tension engendre une tension réduite U à la fois sur le bloc inférieur 3 et sur la cellule de Pockels dont l'impédance électrique est environ mille fois supérieure à celle du bloc inférieur 3.

La cellule de Pockels 4 contient une fibre optique 17 associée à une diode électroluminescente d'émission et une fibre optique 19 associée à une photodiode de réception, reliées à une unité électronique non représentée d'acquisition de signaux représentatifs de la puissance lumineuse continue émise et de la puissance lumineuse instantanée reçue. Un traitement des signaux donne accès à la tension réduite U et calcule la tension totale V à partir des épaisseurs $e_2$ et $e_3$ des deux blocs du diviseur de tension.

Il faut noter que le bâti peut contenir au moins deux cellules de Pockels assurant une fonction redondante.

Un isolateur 25 par exemple en porcelaine ou en composite de forme cylindrique ou tronconique est assemblé mécaniquement par exemple par vissage à l'enceinte blindée au niveau d'un épaulement de fixation 23. L'isolateur 25 est rempli d'un gaz sous pression généralement de même nature que celui 21 contenu dans l'enceinte blindée 20, par exemple l'hexafluorure de Soufre $SF_6$. Un cône de support 27 assure le maintien d'un conducteur électrique 28 provenant de la ligne électrique. Il peut également assurer une séparation étanche entre l'isolateur 25 et l'enceinte blindée 20.

Le conducteur électrique 28 est disposé à l'intérieur de l'isolateur 25 et se prolonge dans l'enceinte blindée par l'intermédiaire d'une ouverture annulaire 29 ménagée au sommet du cône de support 27. Le conducteur électrique 28 relie l'armature 7 du bloc diélectrique supérieur 2 du diviseur de tension 1 à une ligne électrique non représentée supportée par l'isolateur 25.

La chute de potentiel dans le conducteur 28 étant rendue négligeable par le choix d'une section appropriée, la ligne électrique transportant une tension V fournit la même tension au diviseur de tension , l'électrode intermédiaire 5 fournissant une tension réduite U à la cellule de Pockels. La détermination de la tension réduite U par le capteur électro-optique permet d'accéder à la tension V de la ligne électrique.

La figure 2 met en relief les avantages du capteur électro-optique de tension selon l'invention.

D'une part, l'isolateur qui supporte la tension de la ligne électrique ne contient que le conducteur électrique qui transmet la tension jusqu'au diviseur de tension disposé à l'intérieur de l'enceinte blindée. Il en résulte que le risque de court-circuit est circonscrit à l'enceinte blindée conçue pour résister à une augmentation de la température et de la pression du gaz isolant.

De préférence, un disque de rupture 30 libérant un orifice lorsque la pression dépasse un certain seuil est ménagé dans la paroi de l'enceinte blindée de sorte que sa limite de rupture n'est pas atteinte.

Ainsi le capteur électro-optique de tension présente une sécurité très élevée vis à vis des risques d'explosion.

Il faut remarquer que la localisation de la tension de la ligne électrique à l'intérieur de l'enceinte blindée tire parti de la compacité du diviseur de tension, notamment dans le cas où les deux blocs diélectrique homogènes sont constitués de vitrocéramiques.

D'autre part, l'enceinte blindée assure une homogénéisation de la température du gaz isolant en contact avec le diviseur de tension. Les deux blocs diélectriques homogènes se trouvent ainsi sensiblement à la même température.

Il en résulte que le rapport de division R entre la tension totale V et le tension réduite U est indépendant de la température du gaz isolant de l'enceinte blindée, permettant ainsi d'éliminer d'éventuelles dérives du rapport de division R dues à des variations d'origine thermique de la permittivité diélectrique du matériau constitutif des deux blocs. En pratique cela revêt un grand intérêt dans la mesure où il n'est guère concevable au plan industriel de thermostater l'enceinte blindée pour garantir la validité du rapport de division en fonction de la température.

Il faut là aussi souligner l'intérêt de la compacité du diviseur de tension qui permet une homogénéisation thermique rapide et complète des deux blocs diélectriques homogènes, par comparaison avec une colonne capacitive telle celle décrite précédemment dans laquelle un gradient de température existe dans le sens de la longueur de la colonne et engendre une variation capacitive des capacités élémentaires en fonction de leur position dans la colonne.

Il faut noter enfin que l'enceinte blindée assure aussi une totale protection contre les perturbations électromagnétiques pouvant provenir d'autres conducteurs extérieurs sous tension situés au voisinage du capteur électro-optique. La précision de mesure de la tension de la ligne électrique est donc garantie.

Ainsi le capteur électro-optique de tension présente à la fois une stabilité mécanique et thermique qui lui garantit un fonctionnement de grande précision et de grande fiabilité dans le temps sans maintenance particulière.

## Revendications

1. Capteur électro-optique de tension (10) pour déterminer la tension d'une ligne électrique, ledit capteur comprenant un diviseur de tension (1) pouvant être relié à la ligne électrique et à une masse (15) et ayant deux compartiments isolants (2, 3) séparés par une électrode intermédiaire (5) ainsi qu'une cellule de Pockels, ladite électrode intermédiaire étant reliée à la cellule de Pockels et fournissant à la cellule de Pockels une tension réduite de la tension pouvant être fournie par la ligne électrique au diviseur de tension (1), **caractérisé en ce que** chaque compartiment isolant (2, 3) est massif et est constitué d'un bloc diélectrique homogène.

2. Le capteur selon la revendication 1, dans lequel chaque compartiment (2, 3) est constitué d'un bloc de verre ou de vitrocéramique.

3. Le capteur selon la revendication 1 ou 2, dans lequel les deux blocs diélectriques homogènes (2, 3) sont de forme cylindrique et possèdent une même section.

4. Le capteur selon la revendication 3, dans lequel les sections des deux blocs sont revêtues d'un dépôt conducteur.

5. Le capteur selon la revendication 4, dans lequel l'électrode intermédiaire (5) est formée par un collage conducteur des deux blocs diélectriques homogènes (2, 3).

6. Le capteur selon la revendication 3, dans lequel l'un (3) des deux blocs diélectriques homogènes comporte un évidement axial (11) pour le passage d'un fil conducteur (13) reliant l'électrode intermédiaire (5) à la cellule de Pockels (4).

7. Le capteur selon l'une des revendications précédentes, dans lequel le diviseur de tension (1) et la cellule de Pockels (4) sont disposés dans une enceinte blindée (20).

8. Le capteur seton la revendication 7, dans lequel le diviseur de tension (1) peut être relié à la ligne électrique par un conducteur électrique (28) qui est disposé à l'intérieur d'un isolateur (25) et qui se prolonge à l'intérieur de l'enceinte blindée (20).

9. Le capteur selon la revendication 7 ou 8, dans lequel l'enceinte blindée (20) ou l'isolateur (25) sont remplis d'un gaz neutre et sec sous une pression moyenne inférieure à 2 bars.

10. Le capteur selon la revendication 9, dans lequel l'enceinte blindée (20) possède un disque de rupture (30).

**Patentansprüche**

1. Elektro-optischer Spannungsmessfühler (10) zum Bestimmen der Spannung einer elektrischen Leitung, wobei der Messfühler einen Spannungsteiler (1), der mit der elektrischen Leitung und einer Masse (15) verbunden werden kann, und zwei isolierende Fächer (2,3), die durch eine Zwischenelektrode (5) getrennt ist, sowie eine Pockels-Zelle aufweist, wobei die Zwischenelektrode (5) mit der Pockels-Zelle verbunden ist und an die Pockels-Zelle eine Spannung liefert, die um die Spannung, die von der elektrischen Leitung zum Spannungsteiler (1) geliefert werden kann, reduziert ist, **dadurch gekennzeichnet, dass** jedes isolierende Fach (2,3) massiv ist und aus einem homogenen dielektrischen Block gebildet ist.

2. Messfühler nach Anspruch 1, wobei jedes Fach (2,3) aus einem Glasblock oder einem vitrokeramischen Block gebildet ist.

3. Messfühler nach Anspruch 1 oder 2, wobei die beiden homogenen dielektrischen Blöcke (2,3) von zylindrischer Form sind und den gleichen Querschnitt besitzen.

4. Messfühler nach Anspruch 3, wobei die Abschnitte der beiden Blöcke mit einer leitenden Beschichtung überzogen sind.

5. Messfühler nach Anspruch 4, wobei die Zwischenelektrode (5) durch eine leitende Verklebung der beiden homogenen dielektrischen Blöcke (2,3) gebildet ist.

6. Messfühler nach Anspruch 3, wobei einer (3) der beiden homogenen dielektrischen Blöcke eine axiale Ausnehmung (11) für den Durchgang eines Leiterdrahts (13), der die Zwischenelektrode (5) mit der Pockels-Zelle (4) verbindet, umfasst.

7. Messfühler nach einem der vorangehenden Ansprüche, wobei der Spannungsteiler (1) und die Pockels-Zelle (4) in einem gepanzerten Gehäuse (20) angeordnet sind.

8. Messfühler nach Anspruch 7, wobei der Spannungsteiler (1) mit der elektrischen Leitung durch einen elektrischen Leiter (28) verbunden sein kann, welcher im Innern eines Isolators (25) angeordnet ist und sich im Innern des gepanzerten Gehäuses (20) fortsetzt.

9. Messfühler nach Anspruch 7 oder 8, wobei das gepanzerte Gehäuse (20) oder der Isolator (25) mit einem neutralen und trockenen Gas unter einem mittleren Druck unter 2 bar gefüllt ist.

10. Messfühler nach Anspruch 9, wobei das gepanzerte Gehäuse (20) eine Berstscheibe (30) besitzt.

**Claims**

1. Electro-optic voltage sensor (10) for determining the voltage on an electric line, said sensor comprising a voltage divider (1) connectable to said electric line and to ground (15) and having two insulative compartments (2, 3) separated by an intermediate electrode (5) as well as a Pockels cell, said intermediate electrode being connected to the Pockels cell and supplying to said Pockels cell a reduced voltage derived from the voltage, which can be supplied by said electric line to said voltage divider (1), **characterized in that** each solid, insulative compartment (2, 3) is a homogeneous dielectric block.

2. Sensor according to claim 1, **characterized in that** each compartment (2, 3) is a glass or vitroceramic block.

3. Sensor according to claim 1, **characterized in that** said two homogeneous dielectric blocks (2, 3) are cylindrical in shape and have the same cross-section.

4. Sensor according to claim 3, **characterized in that** said cross-sections of said two blocks are coated with a conductive deposit.

5. Sensor according to claim 4, **characterized in that** said intermediate electrode (5) is formed by a conductive bonding of said two homogeneous dielectric blocks (2, 3).

6. Sensor according to claim 3, **characterized in that** one (3) of said two homogeneous dielectric blocks includes an axial opening (11) through which passes a conductive wire (13) connecting said intermediate electrode (5) to said Pockels cell (4).

7. Sensor according to any one of the preceding claims, **characterized in that** said voltage divider (1) and said Pockels cell (4) are disposed in a shielded enclosure.

8. Sensor according to claim 7, **characterized in that** said voltage divider (1) can be connected to said electric line by an electric conductor (28) disposed inside an insulator (25) and which extends into said shielded enclosure (20).

9. Sensor according to claim 7 or 8, **characterized in that** said shielded enclosure (20) or said insulator (25) are filled with a dry, neutral gas at an average pressure less than 2 bars.

10. Sensor according to claim 9, **characterized in that** said shielded enclosure (20) incorporates a rupture disk (30).

# FIG_1

# FIG_2